# EUROPEAN PATENT APPLICATION

(11) **EP 3 667 711 A1**
(43) Date of publication of application: **17.06.2020**
(21) Application number: 18211635.0
(22) Date of filing: 11.12.2018
(51) Int. Cl.: H01L 21/677

(54) **AN ARBITRARY-DISTANCE SAMPLE TRANSFER IN ULTRA-HIGH VACUUM**

(71) Applicant: University of Vienna, 1010 Vienna (AT)
(72) Inventor: The designation of the inventor has not yet been filed
(74) Representative: Karl, Christof

(57) **Abstract**

A system and method for introducing samples into, and moving samples within an ultra-high vacuum chamber comprising one or more vacuum tubes, comprising one or more movable devices comprising a support member for supporting a sample, wherein the movable device is configured to be freely movable within the one or more vacuum tubes, and wherein movement of the movable device is controlled by means of a movable magnetic field generated external to the vacuum tubes.

## Description

### Technical Field

The present invention relates to a system for manipulation and navigation of samples within a high-vacuum or ultra-high vacuum (UHV) system.

### Background

Moving samples around inside of a high-vacuum or ultra-high vacuum (UHV) system requires elaborate technical solutions, primarily due to the very limited choice of materials that do not outgas and thereby disrupt the vacuum. Existing solutions are based on transfer arms, which require at least twice as much space as the required transfer length. Transfer arms take up a lot of space outside of the vacuum system, and samples have to be handed over from one arm to another for going around corners. The arms are also very expensive due to the required high precision manufacturing.

### Summary of invention

In order to solve the aforementioned problems, the present invention provides a system for introducing samples into, and moving samples within an ultra-high vacuum (UHV) chamber comprising one or more vacuum tubes. According to present invention, the system comprises one or more movable devices which each comprise a support member for supporting a sample. Furthermore, the movable device is configured to be freely movable within the one or more vacuum tubes of the UHV chamber. Once introduced into the vacuum tubes, movement of the movable device is controlled by means of a movable magnetic field generated external to the vacuum tubes. The solution of the present invention thereby advantageously enables accurate positioning of samples within an ultra-high vacuum. Furthermore, the solution of the present invention beneficially obviates the need for large unwieldy transport arms.

According to a preferred embodiment of the invention, the movable device comprises at least two wheels connected to the support member. The wheels advantageously reduce friction between the movable device and the internal walls of the vacuum tube.

According to a further preferred embodiment of the invention, at least part of the movable device is made of a ferromagnetic material. This enables the movement of the movable device to be controlled by means of the magnetic field generated from outside the vacuum tubes.

According to a further preferred embodiment of the invention, one or more magnets are arranged on or in the movable device. This can be implemented with or without part of the movable device being made of a ferromagnetic material to improve the control of movement of the movable device within the vacuum tubes by the magnetic field generated from outside the vacuum tubes.

According to another preferred embodiment of the invention, the one or more vacuum tubes comprise a container configured to house the one or more movable devices. The container is further configured to form an airtight interface with at least one of the one or more vacuum tubes of the ultra-high vacuum chamber. The container is at least large enough to fully house the one or more movable devices and preferably has the same or a similar diameter to that of the vacuum tubes. One end of the container may be closed whilst the other open to receive the one or more movable devices. The open end of the container is configured to interface with an opening of at least one of the one or more vacuum tubes. This facilitates introducing the movable device and sample into the vacuum tubes and subsequent access to the movable device and sample. In a preferred embodiment thereof, the container comprises a removable section of one of the vacuum tubes. In a further preferred embodiment thereof, the section comprises a gate valve. This enables access to the movable device and sample without necessitating halting operation of the vacuum since, due to the gate valve, the container may be isolated from the vacuum tube it is coupled with and thereby isolated from the UHV system during operation. In other words, the container effectively forms an "airlock" by which the movable device and samples thereon may be conveniently introduced and removed from the UHV system. This thereby reduces the downtime normally incurred when introducing and removing samples from the vacuum tube as it enables the operation of the UHV vacuum chamber and vacuum tubes to continue throughout the procedure. In another preferred embodiment of the aforementioned embodiments, the container is formed in a Y-shape with three tube portions, wherein one of the tube portions is configured to form an interface with one of the vacuum tubes of the ultra-high vacuum chamber, preferably via the gate valve, and one or more of the other two portions are configured to receive the one or more movable devices. This advantageously enables introduction and removal of multiple devices and samples into and from the vacuum tubes of the UHV chamber and can further reduce downtime and latency.

In another preferred embodiment, the movable device comprises a spring-loaded container. This provides improved securing of the sample to the movable device.

In a further preferred embodiment, the movable device comprises multiple magnets. This enables improved control of movement of the movable device and sample along non-uniform sections of the vacuum tubes such as flanges, gate valves, curves etc.

According to yet another embodiment, the magnetic field is provided by one or more permanent magnets. In an alternative embodiment thereto, the magnetic field is provided by one or more electromagnets.

In a further aspect of the invention, a method for introducing samples into, and moving samples within an ultra-high vacuum chamber comprising one or more vacuum tubes is provided. The method comprises the steps of introducing one or more movable devices comprising a support member for supporting a sample into at least one of the one or more vacuum tubes and controlling the movement of the one or more movable devices within the one or more vacuum tubes by generating and manipulating a magnetic field external to the one or more vacuum tubes. The one or more movable devices may preferably include some or all of the additional features of the above preferred embodiments of the aforementioned system.

According to a preferred embodiment of the method, the one or more movable devices are housed in a container which is subsequently coupled with at least one of the one or more vacuum tubes by forming an airtight interface between the container and the at least one of the one or more vacuum tubes.

In a further preferred embodiment of the method a container is provided in the form of a Y-shaped section with three tube portions, wherein multiple movable devices are housed in two of the tube portions and the multiple movable devices are, by moving the magnetic field, moved into the one or more vacuum tubes via the third tube portion which forms the airtight interface between the container and the at least one or more vacuum tubes.

### Brief description of the drawings

Fig. 1 shows a preferred exemplary implementation of the present invention.
Fig. 2 is a drawing of a sample movable device or "shuttle" that is driven by the attraction between strong magnets on the shuttle and magnets on the outside of the vacuum tube. The external magnets can be moved by hand or automatically.

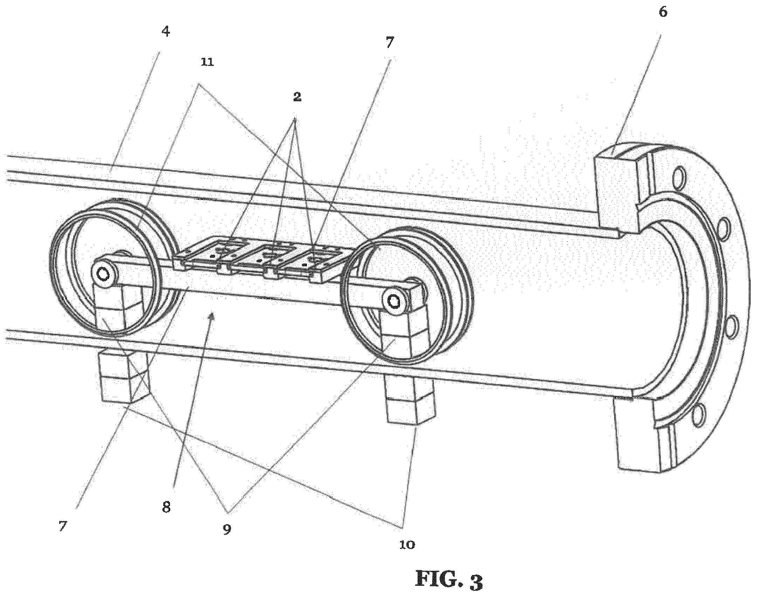

Fig. 3 is a CAD drawing of the movable device according to a preferred embodiment of the invention.

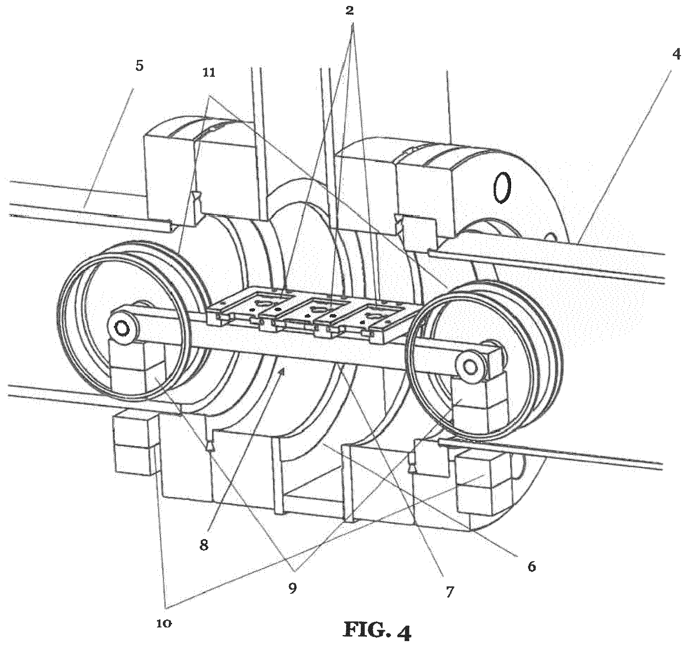

Fig. 4 is a CAD model of a shuttle driving through a gate-valve. For driving across the gate, only one external magnet is used whenever the other internal magnet is inside the gate valve.

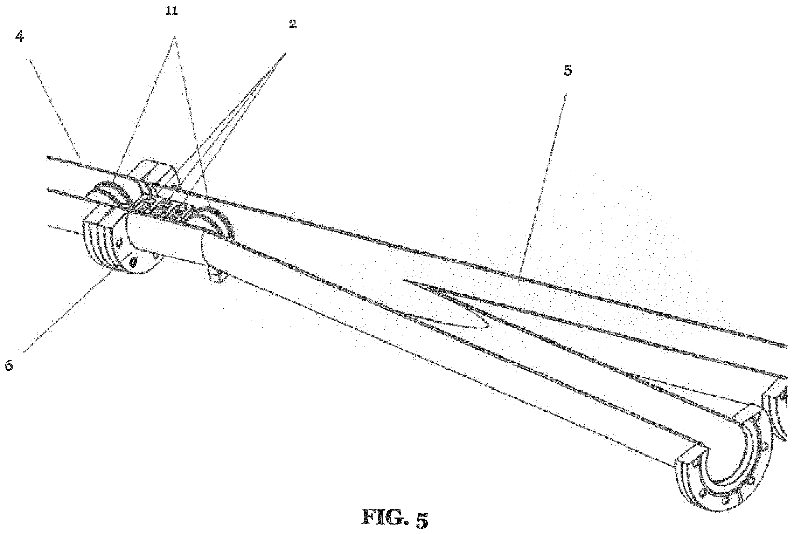

Fig. 5 is a CAD model showing a removable Y-shaped section of the vacuum tube enabling branching of the vacuum tubes of the UHV system.

### Preferred exemplary implementation of the invention

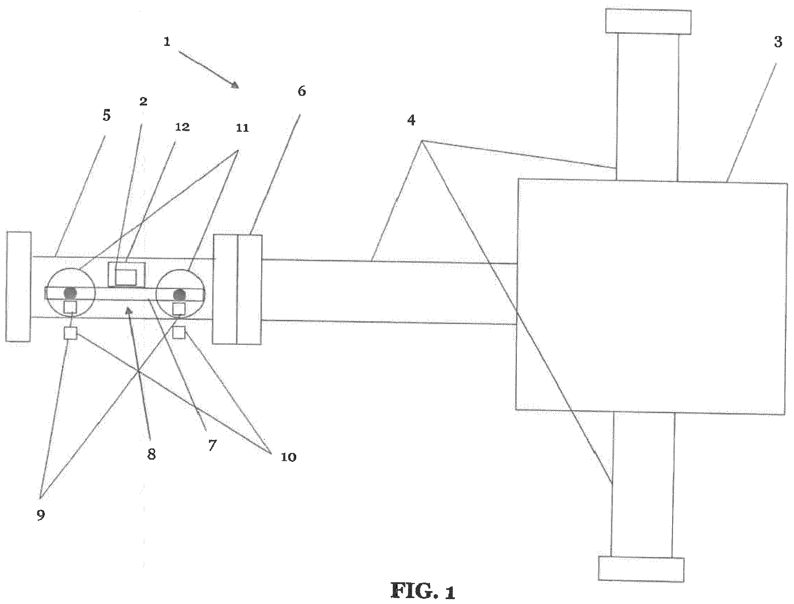

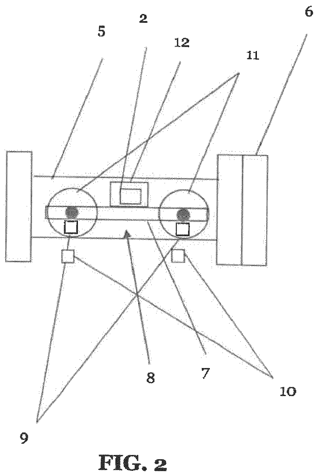

In a preferred implementation of the present invention as shown in Figs. 1 and 2, a system 1 for introducing samples 2 within an UHV chamber 3 is provided. The UHV chamber 3 comprises a plurality of vacuum tubes 4. In order for the samples 2 to be introduced into the UHV chamber 3, at least one of the vacuum tubes 4 includes a container 5 which can be isolated from the UHV chamber 3 and vacuum tubes 4 thereof. In a first preferred embodiment of the implementation, the container 5 configured to be isolated from the UHV chamber 3 and vacuum tubes 4 thereof is preferably a discrete tubular chamber 5 of the same diameter as one of the vacuum tubes 4 and which is connectable the vacuum tube 4 by means of a gate valve 6 which acts as an airtight interface between the UHV chamber 3 and the container 5 when connected thereto. This enables the container 5 to be connected to and removed from the vacuum tube 4 without having to halt operation of the UHV chamber 3 i.e. the vacuum formed within the UHV chamber and vacuum tubes 4 may be maintained upon connecting or removing the container 5 from the vacuum tube 4. The container 5 is configured to accommodate a sample 2 which is to be introduced into the vacuum tube 4 and subsequently into the UHV chamber 3. In order to transport the sample 2 from the removable section 5 into the vacuum tube 4 and subsequently into the UHV vacuum chamber 3, the sample 2 is placed on the support 7 of a device 8 which is freely movable within the vacuum chamber 4. The device 8 comprises one or more magnets 9 which are preferably arranged thereon and/or therein. Once the section 5 has been securely connected to the vacuum tube 4 via the gate valve 6 forming a hermetic seal, the gate valve 6 may be opened in order to provide access between the vacuum tube 4 of the UHV chamber 3 and the container 5 including the movable device 8 and sample 2. The sample 2 may then be moved from inside the container 5 and introduced into the vacuum tube 4 by means of the movable device 8 since the movable device 8 is freely movable within the section 5 and vacuum tube 4. In order to move the movable device 8, one or more permanent magnets or an electromagnet 10 configured to produce a movable magnetic field from a location external to the container 5, vacuum tube 4 and UHV chamber 3 is brought in close proximity to the container 5 where the movable device 8 is located. By moving the magnet 10 external to the vacuum tube 4 and UHV chamber 3, the magnetic field forms either an attractive or repulsive force toward the magnets 9 of the movable device 8 thereby enabling movement of the movable device 8 freely within the container 5 and vacuum tube 4 corresponding to moving the position of the magnet 10 external to the container 5 and the vacuum tube 4. In order to reduce friction between the movable device 8 and the internal walls of the container 5 and vacuum tube 4, the device comprises two or more wheels 11 mounted thereon to facilitate movement along the vacuum tube 4. The sample 2 is ideally secured to the support of the movable device 8 by securing means such as a spring-loaded container 12. After having been moved to the location required and all procedures such as experiments performed, the sample 2 may be moved back to the removable container 5 by again manipulating the magnet 10 external to the vacuum tube 4 when the magnet 10 is in close proximity to the location of the movable device 8 and in similar manner to the aforementioned description of moving the sample 2 into the vacuum tube 4.

## Claims

1. A system (1) for introducing samples (2) into, and moving samples within an ultra-high vacuum chamber (3) comprising one or more vacuum tubes (4), the system comprising:
one or more movable devices (8) comprising a support member (7) for supporting a sample, wherein the movable device is configured to be freely movable within the one or more vacuum tubes, and wherein movement of the movable device is controlled by means of a movable magnetic field generated external to the vacuum tubes.

2. The system according to claim 1, wherein the movable device comprises at least two wheels (11) connected to the support member.

3. The system according to claims 1 or 2, wherein at least part of the movable device is made of a ferromagnetic material.

4. The system according to claims 1 to 3, wherein one or more magnets (9) are arranged on or in the movable device.

5. The system according to claims 1 to 4, wherein the system comprises a container (5) configured to house the one or more movable devices and configured to form an airtight interface with at least one of the one or more vacuum tubes.

6. The system according to claim 5, wherein the container comprises a removable section of one of the vacuum tubes.

7. The system according to claim 6, wherein the section comprises a gate valve (6).

8. The system according to claims 5 to 7, wherein the container is formed in a Y-shape with three tube portions, wherein one tube portion is configured to form the airtight interface and one or more of the other two portions are configured to receive the one or more movable devices.

9. The system according to any of the preceding claims, wherein the movable device comprises a spring-loaded container (12).

10. The system according to any of the preceding claims, wherein the movable device comprises multiple magnets.

11. The system according to any of the preceding claims, wherein the magnetic field is provided by one or more permanent magnets (10).

12. The system according to any of the preceding claims, wherein the magnetic field is provided by one or more electromagnets.

13. A method for introducing samples (2) into, and moving samples within an ultra-high vacuum chamber (3) comprising one or more vacuum tubes (4), the method comprising the steps of:
introducing one or more movable devices (8) comprising a support member (7) for supporting a sample into at least one of the one or more vacuum tubes;
controlling the movement of the one or more movable devices within the one or more vacuum tubes by generating and manipulating a magnetic field external to the one or more vacuum tubes.

14. The method of claim 13, further comprising housing the one or more movable devices in a container and coupling the container with at least one of the one or more vacuum tubes by forming an airtight interface between the container and the at least one of the one or more vacuum tubes.

15. The method of claim 13 or claim 14, further comprising providing a container as a Y-shaped section with three tube portions, housing multiple movable devices in two of the tube portions, moving multiple movable devices into the one or more vacuum tubes by moving the magnetic field.
